# FASCICULE DE BREVET EUROPEEN

(11) **EP 4 339 107 B1**
(45) Date de publication et mention de la délivrance du brevet: **23.07.2025**
(21) Numéro de dépôt: 23197967.5
(22) Date de dépôt: 18.09.2023
(51) Int. Cl.: B64F 5/60, B64F 5/40, G05B 23/02, G06N 20/00, G06N 3/08

(54) **PROCEDE DE DETECTION DE DYSFONCTIONNEMENT SUBI PAR UN GENERATEUR D'ENTRAINEMENT INTEGRE, DANS UN AERONEF**
VERFAHREN ZUR ERKENNUNG VON FEHLFUNKTIONEN EINES INTEGRIERTEN ANTRIEBSGENERATORS IN EINEM FLUGZEUG
METHOD FOR DETECTING MALFUNCTION OF AN INTEGRATED DRIVE GENERATOR IN AN AIRCRAFT

(30) Priorité: 19.09.2022 FR 2209447
(43) Date de publication de la demande: 20.03.2024
(73) Titulaire: Airbus Operations (S.A.S.), 31060 Toulouse Cedex 9 (FR)
(72) Inventeur: BROUQUI, Manon, 31060 TOULOUSE (FR); BRADIER, Matthieu, 31060 TOULOUSE (FR); BENHAMOU, Eric, 31026 TOULOUSE Cedex 3 (FR)
(74) Mandataire: Cabinet Le Guen Maillet

(56) Documents cités:
- EP-A1- 3 460 611
- US-A1- 2020 382 031
- BRIAN KEITH BAILEY: "Fault Diagnosis Via Univariate Frequency Analysis Monitoring: A Novel Technique Applied to a Simulated Integrated Drive Generator", 31 May 2012 (2012-05-31), XP055706551, Retrieved from the Internet <URL:https://trace.tennessee.edu/cgi/viewcontent.cgi?article=2185&context=utk_gradthes> [retrieved on 20200618]

## Description

### DOMAINE TECHNIQUE

La présente invention concerne le domaine de la détection de dysfonctionnement subi par un générateur d'entraînement intégré IDG (« Integrated Drive Generator » en anglais) dans un aéronef.

### ETAT DE LA TECHNIQUE ANTERIEURE

Dans un aéronef, un IDG est un système associé à chaque moteur de propulsion (turbomachine) afin de convertir l'énergie cinétique dudit moteur de propulsion en énergie électrique pour fournir de l'électricité à l'aéronef. L'IDG fournit potentiellement une alimentation électrique à toutes les charges électriques de l'aéronef.

L'IDG se compose d'un alternateur et d'un entraînement à vitesse constante CSD (« Constant Speed Drive » en anglais) montés dans un même boîtier. Le CSD est un dispositif mécanique permettant d'obtenir une fréquence constante de rotation en entrée de l'alternateur malgré les variations de vitesse de rotation du moteur de propulsion. Ainsi, l'IDG peut délivrer une fréquence fixe (par exemple, 400 Hz) au réseau électrique de l'aéronef.

L'huile est un composant vital de l'IDG, et l'adéquation des caractéristiques de cette huile, notamment sa température, avec les spécifications est un paramètre essentiel pour la longévité et l'efficacité de l'IDG. En cas contraire, il est considéré que l'IDG subit un dysfonctionnement, qu'il est souhaitable de détecter.

L'huile utilisée pour le refroidissement de l'IDG circule en circuit fermé et est refroidie, par le biais d'un refroidisseur d'huile (« oil cooler » en anglais), grâce au carburant alimentant le moteur de propulsion auquel est associé l'IDG. De la même manière, un échangeur de chaleur (« heat exchanger » en anglais) est utilisé pour refroidir l'huile utilisée pour la lubrification du moteur à propulsion lui-même. Les échanges de chaleur permettant le refroidissement de ces huiles dépendent donc du flux de carburant alimentant le moteur de propulsion en question.

Or, comme pendant certaines phases de vol, et plus particulièrement en phase de descente, le besoin en carburant du moteur de propulsion est moindre, le carburant alimentant le moteur de propulsion peut ne pas suffire au refroidissement de ces huiles, ce qui réduit la longévité et la performance de l'IDG.

Pour prendre en compte cet aspect, une vanne de retour carburant FRV (« Fuel Return Valve » en anglais) est utilisée, de manière à accroître le flux de carburant pour maintenir le refroidissement. La FRV contrôle le flux de carburant depuis un système de distribution de carburant au moteur de propulsion vers un système de recirculation renvoyant le carburant chaud vers le réservoir de carburant de l'aéronef. Lorsque la FRV est en position fermée, le système de recirculation est inhibé.

Il ressort de ce qui précède que, lorsque la FRV subit un dysfonctionnement, que ce soit dû à une panne de la FRV elle-même ou à une panne d'un autre organe avec lequel l'IDG interagit, directement ou indirectement, comme un capteur ou la FRV, l'IDG subit lui-même un dysfonctionnement, et la longévité et la performance de l'IDG peuvent s'en trouver amoindries.

Il est alors souhaitable de pallier ces inconvénients de l'état de la technique. Il est notamment souhaitable de fournir une solution qui permette de détecter un dysfonctionnement subi par l'IDG. Il est par ailleurs souhaitable de fournir une solution qui permette d'identifier la cause du dysfonctionnement détecté. Il est par ailleurs souhaitable de fournir une solution qui soit simple et peu coûteuse.

D'après son résumé, le document US2020382031 A1 divulgue une méthode de prévision de l'état de santé d'un générateur d'entraînement intégré (IDG) comprenant la détermination d'un écart effectif entre plusieurs fréquences de sortie de l'IDG pour une période de fonctionnement donnée de l'IDG. La méthode consiste à corréler l'écart effectif à une capacité du générateur d'entraînement intégré afin de déterminer l'état de santé du générateur d'entraînement intégré. Un système permettant de prédire l'état de santé d'un générateur à entraînement intégré (IDG) comprend un IDG et une unité de commande de générateur (GCU) connectée de manière opérationnelle à l'IDG pour déterminer une pluralité de fréquences de sortie de l'IDG pour une période de fonctionnement donnée de l'IDG. Le système comprend une unité centrale de traitement (CPU) connectée de manière opérationnelle à l'unité de contrôle du générateur pour recevoir les fréquences de sortie du générateur. L'unité centrale de traitement est configurée et adaptée pour déterminer un écart effectif sur au moins une partie de la pluralité de fréquences de sortie de l'IDG pour la période de fonctionnement donnée de l'IDG, et pour corréler l'écart effectif à une capacité de l'IDG afin de déterminer l'état de santé de l'IDG.

D'après son résumé, le document EP3460611 A1 divulgue un système de détection de défauts d'aéronef comprenant au moins un dispositif d'enregistrement de données d'aéronef configuré pour capturer des données de vol paramétriques à partir d'au moins un sous-système d'aéronef, et un contrôleur d'aéronef couplé au dispositif d'enregistrement de données.

D'après son résumé, le document XP055706551 "Fault Diagnosis Via Univariate Frequency Analysis Monitoring: A Novel Technique Applied to a Simulated Integrated Drive Generator" par Brian Keith Bailey (https://trace.tennessee.edu/utk_gradthes/1129) divulgue une méthode de détection et de diagnostic des défauts qui permettrait de détecter et d'isoler les défauts en germe dans les données générées à partir d'un générateur d'entraînement intégré simulé.

### EXPOSE DE L'INVENTION

A cet effet, il est proposé un procédé de détection de dysfonctionnement subi par un générateur d'entraînement intégré, dit IDG à surveiller, dans un aéronef, le procédé étant implémenté par un système d'analyse de données comportant une intelligence artificielle de type apprentissage machine. Le procédé comporte : collecter des données de référence relatives à des mesures effectuées et enregistrées pendant des vols antérieurs d'aéronefs équipés d'IDG, dits IDG de référence, les données de référence comportant au moins des mesures correspondant aux paramètres suivants, pour chaque IDG de référence : débit de carburant pour alimenter un moteur de propulsion auquel l'IDG de référence en question est associé ; position d'une vanne de retour carburant associée à l'IDG de référence en question ; température mesurée par un capteur en port d'entrée de l'IDG de référence en question ; température mesurée par un capteur en port de sortie de l'IDG de référence en question ; fréquence de signal électrique produit par l'IDG de référence en question ; température d'huile alimentant le moteur de propulsion auquel l'IDG de référence en question est associé. Le procédé comporte en outre : effectuer un entraînement, en mode supervisé, l'intelligence artificielle de type apprentissage machine grâce aux données de référence, avec une première passe de classification pour entraîner à détecter d'éventuels dysfonctionnements subis par des IDG et une deuxième passe de classification pour entraîner à déterminer des causes des dysfonctionnements le cas échéant ; mettre en production l'intelligence artificielle de type apprentissage machine après validation de l'entraînement ; collecter des données à analyser, de même type que les données de référence, relatives à des mesures effectuées et enregistrées pendant des vols de l'aéronef comportant l'IDG à surveiller ; utiliser l'intelligence artificielle de type apprentissage machine qui a été entraînée, et prédire ainsi un éventuel dysfonctionnement subi par l'IDG à surveiller et prédire, le cas échéant, une cause des dysfonctionnements, grâce respectivement auxdites première et deuxième passes, à partir des données à analyser. Ainsi, le dysfonctionnement d'IDG peut être aisément prédit et, le cas échéant, sa cause peut être aisément prédite aussi.

Dans un mode de réalisation particulier, les données de référence comportent en outre des mesures correspondant à au moins l'un des paramètres suivants, pour chaque IDG de référence : durée durant laquelle la vanne de retour carburant est ouverte ; durée durant laquelle la vanne de retour carburant est fermée ; rapport entre la durée durant laquelle la vanne de retour carburant est fermée et la durée durant laquelle la vanne de retour carburant est ouverte ; durée mise par la vanne de retour carburant pour passer de position fermée à position ouverture ; différence de température entre port d'entrée de l'IDG de référence en question et port de sortie de l'IDG de référence en question.

Dans un mode de réalisation particulier, le système d'analyse de données applique un traitement sur les données de référence et sur les données à analyser, le traitement appliqué correspondant au moins au calcul des informations suivantes, éventuellement en combinaison, pour un ou plusieurs desdits paramètres : valeur minimum ; valeur maximum ; écart-type ; moyenne ; moyenne glissante ; coefficient directeur de pente.

Dans un mode de réalisation particulier, le calcul d'au moins une partie desdites informations est réalisé en regroupant des données de référence, et respectivement des données à analyser, sur plusieurs vols consécutifs d'aéronefs.

Dans un mode de réalisation particulier, l'intelligence artificielle de type apprentissage machine est entraînée pour détecter un dysfonctionnement d'IDG lié à : une anomalie de contrôle d'ouverture/fermeture de vanne de retour carburant ; un colmatage d'huile d'IDG ; une défaillance de capteur de température en port de sortie d'IDG ; une défaillance de capteur de température en port d'entrée d'IDG ; une fuite d'huile d'IDG ; une anomalie d'entretien d'IDG.

Dans un mode de réalisation particulier, la première passe de classification est effectuée en appliquant un premier algorithme et la seconde passe de classification est effectuée en appliquant un second algorithme distinct du premier algorithme.

Dans un mode de réalisation particulier, le premier algorithme est de type LightGBM et le second algorithme est de type XGBooost.

Il est aussi proposé un produit programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus dans l'un quelconque de ses modes de réalisation, lorsque ledit programme est exécuté par le processeur. Il est aussi proposé un support non-transitoire de stockage d'informations sur lequel est stocké un tel programme d'ordinateur.

Dans un mode de réalisation particulier, l'intelligence artificielle de type apprentissage machine est mise en production dans une avionique de l'aéronef équipé de l'IDG à surveiller.

Dans un mode de réalisation particulier, l'intelligence artificielle de type apprentissage machine est mise en production dans un équipement informatique au sol dans un centre de contrôle, et les données à analyser sont transmises par une avionique de l'aéronef équipé de l'IDG à surveiller à l'équipement informatique du centre de contrôle.

Il est aussi proposé un système d'analyse de données comportant une intelligence artificielle de type apprentissage machine, le système comportant une circuiterie électronique configurée pour effectuer une détection de dysfonctionnement subi par un générateur d'entraînement intégré, dit IDG à surveiller, dans un aéronef. La circuiterie électronique est configurée pour collecter des données de référence relatives à des mesures effectuées et enregistrées pendant des vols antérieurs d'aéronefs équipés d'IDG, dits IDG de référence, les données de référence comportant au moins des mesures correspondant aux paramètres suivants, pour chaque IDG de référence : débit de carburant pour alimenter un moteur de propulsion auquel l'IDG de référence en question est associé ; position d'une vanne de retour carburant associée à l'IDG de référence en question ; température mesurée par un capteur en port d'entrée de l'IDG de référence en question ; température mesurée par un capteur en port de sortie de l'IDG de référence en question ; fréquence de signal électrique produit par l'IDG de référence en question ; température d'huile alimentant le moteur de propulsion auquel l'IDG de référence en question est associé. La circuiterie électronique est en outre configurée pour : effectuer un entraînement, en mode supervisé, l'intelligence artificielle de type apprentissage machine grâce aux données de référence, avec une première passe de classification pour entraîner à détecter d'éventuels dysfonctionnements subis par des IDG et une deuxième passe de classification pour entraîner à déterminer des causes des dysfonctionnements le cas échéant ; mettre en production l'intelligence artificielle de type apprentissage machine après validation de l'entraînement ; collecter des données à analyser, de même type que les données de référence, relatives à des mesures effectuées et enregistrées pendant des vols de l'aéronef comportant l'IDG à surveiller ; utiliser l'intelligence artificielle de type apprentissage machine qui a été entraînée, et prédire ainsi un éventuel dysfonctionnement subi par l'IDG à surveiller et prédire, le cas échéant, une cause des dysfonctionnements, grâce respectivement auxdites première et deuxième passes, à partir des données à analyser.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement, en vue de dessus, un aéronef équipé de moteurs à propulsion respectivement munis de générateurs d'entraînement intégrés IDG ;
[Fig. 2A] illustre schématiquement un algorithme d'obtention de données utilisables pour entraîner et valider une intelligence artificielle de type apprentissage machine ;
[Fig. 2B] illustre schématiquement un algorithme d'entraînement et de validation de l'intelligence artificielle de type apprentissage machine ;
[Fig. 3A] illustre schématiquement un algorithme d'obtention de données à analyser par l'intelligence artificielle de type apprentissage machine, afin de détecter d'éventuels dysfonctionnements d'un générateur d'entraînement intégré et, auquel cas, d'en trouver les causes ;
[Fig. 3B] illustre schématiquement un algorithme d'analyse de données par l'intelligence artificielle de type apprentissage machine, afin de détecter les éventuels dysfonctionnements d'un générateur d'entraînement intégré et, auquel cas, d'en trouver les causes ;
[Fig. 4] illustre schématiquement un algorithme de configuration et d'utilisation de l'intelligence artificielle de type apprentissage machine ; et
[Fig. 5] illustre schématiquement un exemple de plateforme matérielle configurée pour réaliser une implémentation de l'intelligence artificielle de type apprentissage machine.

### EXPOSE DETAILLE DE MODES DE REALISATION

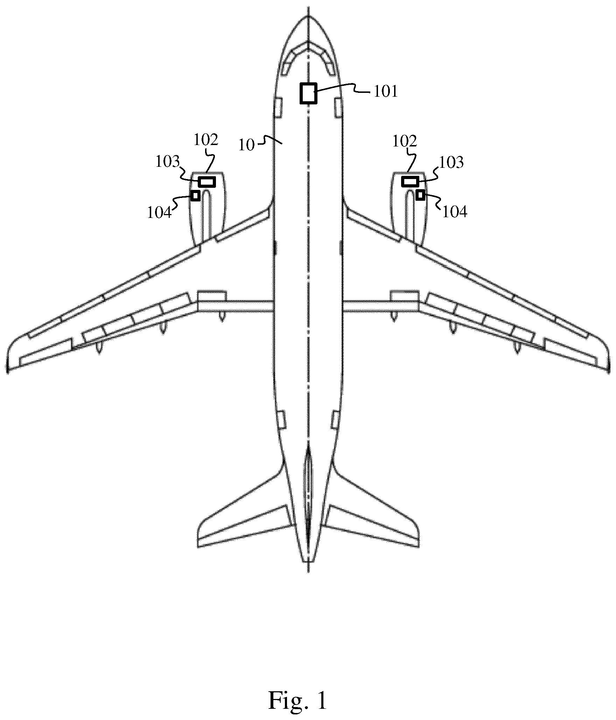

La **Fig. 1** illustre ainsi schématiquement, en vue de dessus, un aéronef 10. L'aéronef 10 comporte au moins un moteur de propulsion 102, préférentiellement de type turbomachine. Chaque moteur de propulsion 102 est muni d'un générateur d'entraînement intégré IDG 103. Chaque moteur de propulsion 102 est aussi préférentiellement muni d'une unité de contrôle de générateur GCU (« Generator Control Unit » en anglais) dont les fonctions principales sont de réguler et surveiller la fréquence et la tension de l'alternateur de l'IDG 103 du moteur de propulsion 102 en question, de surveiller les défauts "feeder", les surcharges et les inversions de phases, et de protéger le réseau électrique de l'aéronef 10 en commandant un contacteur de ligne de générateur GLC (« Generator Line Contactor » en anglais) associé. Chaque GCU est connectée à l'avionique 101 de l'aéronef 10, plus particulièrement à un système de surveillance électronique centralisé de l'aéronef ECAM (« Electronic Centralized Aircraft Monitoring » en anglais), de sorte à fournir au besoin des signaux d'alerte, notamment dans le cockpit de l'aéronef 10.

Chaque IDG 103 est classiquement équipé de deux capteurs de température d'huile : un capteur de température d'huile en port d'entrée (« inlet port » en anglais) et un autre capteur de température d'huile en port de sortie (« outlet port » en anglais). Ces capteurs sont typiquement des thermistors. Grâce à ces capteurs, la GCU associée à l'IDG 103 en question surveille la température de l'huile de l'IDG 103 et fournit un signal d'alerte en cas de dépassement de seuil prédéfini de température sur l'un et/ou l'autre de ces deux capteurs de température d'huile.

Chaque IDG 103 est préférentiellement associé à une vanne de retour carburant FRV 104 qui contrôle le flux de carburant, servant notamment au refroidissement de l'huile de l'IDG 103, depuis un système de distribution de carburant au moteur de propulsion 102, auquel est associé l'IDG 103, vers un système de recirculation renvoyant du carburant chaud vers un réservoir de carburant de l'aéronef afin de permettre d'injecter dans le système de distribution de carburant du carburant plus froid en provenance dudit réservoir de carburant de l'aéronef. La FRV 104 contrôle aussi ledit flux de carburant pour le refroidissement de l'huile dudit moteur de propulsion 102. Ainsi, l'huile de l'IDG 103 en question et l'huile dudit moteur de propulsion 102 sont mieux refroidies. A noter que les moteurs de propulsion 102 sont munis de capteurs de température de l'huile les alimentant.

Un dysfonctionnement de ces capteurs de température ou de la FRV 104, ou d'une unité de contrôle de détection de niveau de carburant FLSCU (« Fuel Level Sensing Control Unit » en anglais), ou de tout autre organe avec lequel l'IDG 103 en question interagit, directement ou indirectement, peut entraîner un dysfonctionnement, parfois à long terme, de l'IDG 103. Pour détecter d'éventuels dysfonctionnements de l'IDG 103 en question et d'en trouver les causes, un système d'analyse de données est utilisé. Le système d'analyse de données est basé sur une intelligence artificielle de type apprentissage machine, tel qu'un réseau de neurones artificiel ou une machine à vecteurs de support SVM (« Support Vector Machine » en anglais), comme décrit ci-après.

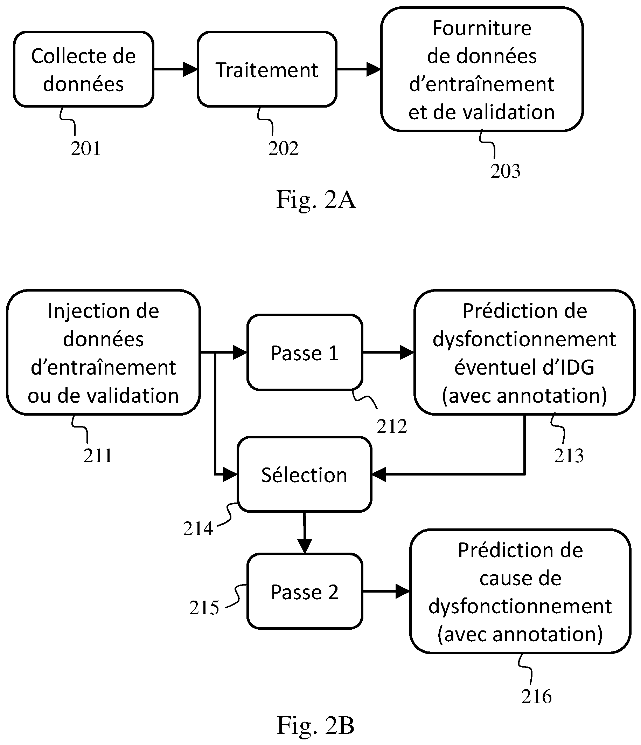

La **Fig. 2A** illustre schématiquement un algorithme d'obtention de données utilisables pour entraîner et valider l'intelligence artificielle de type apprentissage machine.

Dans une étape 201, le système d'analyse de données effectue une collecte de données de référence relatives à des mesures effectuées et enregistrées pendant des vols d'aéronefs. Les données comportent au moins des mesures relatives au fonctionnement et paramétrage des IDG 103 de ces aéronefs et de tout autre organe avec lequel ces IDG 103 interagissent, directement ou indirectement. Préférentiellement, les mesures correspondent au moins aux paramètres suivants, pour chaque IDG 103 concerné :
- Débit de carburant pour alimenter le moteur de propulsion 102 auquel l'IDG 103 en question est associé ;
- Position (ouverte/fermée) de la FRV 104 associée à l'IDG 103 en question ;
- Température mesurée par le capteur en port d'entrée de l'IDG 103 en question ;
- Température mesurée par le capteur en port de sortie de l'IDG 103 en question ;
- Fréquence du signal électrique produit par l'IDG 103 en question ;
- Température de l'huile alimentant le moteur de propulsion 102 auquel l'IDG 103 en question est associé.

Dans un mode de réalisation particulier, la liste de paramètres ci-dessus est complétée par les paramètres suivants :
- Durée durant laquelle la vanne de retour carburant est ouverte ;
- Durée durant laquelle la vanne de retour carburant est fermée ;
- Rapport entre la durée durant laquelle la vanne de retour carburant est fermée et la durée durant laquelle la vanne de retour carburant est ouverte ;
- Durée mise par la vanne de retour carburant pour passer de position fermée à position ouverture ;
- Différence de température entre port d'entrée de l'IDG et port de sortie de l'IDG.

Dans une étape 202, le système d'analyse de données effectue préférentiellement un traitement sur les données collectées à l'étape 201. Le traitement comporte par exemple des opérations de sélection, de transformation, d'agrégation et de combinaison. Préférentiellement, le traitement appliqué correspond au moins au calcul des informations suivantes, éventuellement en combinaison, pour un ou plusieurs des paramètres listés ci-dessus :
- Valeur minimum ;
- Valeur maximum ;
- Ecart-type ;
- Moyenne ;
- Moyenne glissante ;
- Coefficient directeur de pente.

Dans un mode de réalisation particulier, le calcul d'au moins une partie desdites informations est réalisé en regroupant des données de référence, et respectivement des données à analyser, sur plusieurs vols consécutifs d'aéronefs. Par exemple, le traitement de données ressort une moyenne glissante, sur une quantité prédéfinie de vols consécutifs d'aéronefs, de la différence de température entre port d'entrée d'IDG 103 et port de sortie d'IDG 103 (e.g., température en port d'entrée moins température en port de sortie). Selon un autre exemple, le traitement de données ressort un coefficient directeur de pente de la moyenne glissante, sur une fenêtre prédéfinie de vols consécutifs d'aéronefs, de la moyenne (par vol ou par segment de vol de croisière) de la différence de température entre port d'entrée d'IDG 103 et port de sortie d'IDG 103 (e.g., température en port d'entrée moins température en port de sortie). Selon un autre exemple, le traitement de données ressort un coefficient directeur de pente, sur une quantité prédéfinie de vols consécutifs d'aéronefs, de la valeur maximum (ou minimum, ou de la moyenne, ou de l'écart-type) de la différence de température entre port d'entrée d'IDG 103 et port de sortie d'IDG 103 (e.g., température en port d'entrée moins température en port de sortie).

Dans une étape 203, le système d'analyse de données fournit un jeu de données, issues des données collectées et préférentiellement issues du traitement de l'étape 202, utilisables pour l'entraînement et la validation de l'intelligence artificielle de type apprentissage machine.

La **Fig. 2B** illustre schématiquement un algorithme d'entraînement et de validation de l'intelligence artificielle de type apprentissage machine.

Dans une étape 211, le système d'analyse de données injecte un jeu de données d'entraînement en entrée de l'intelligence artificielle de type apprentissage machine. Le jeu de données fourni dans l'étape 203 est séparé en deux jeux de données : le jeu de données d'entraînement et un jeu de données de validation.

L'entraînement de l'intelligence artificielle de type apprentissage machine est effectué de manière supervisée. En d'autres termes, un opérateur humain annote les données du jeu de données en question, afin d'indiquer à l'intelligence artificielle de type apprentissage machine la classification attendue pour les données injectées en entrée. L'intelligence artificielle de type apprentissage machine se configure en tenant compte des données injectées en entrée et de l'annotation fournie. Les données sont classifiées au regard de dysfonctionnements éventuellement constatés ultérieurement sur les IDG 103 concernés par les données collectées.

Préférentiellement, les données sont classifiées avec une indication du temps écoulé ou nombres de vols effectués entre les mesures concernées et la constatation du dysfonctionnement. Cela permet à l'intelligence artificielle d'apprendre à prédire la survenue de dysfonctionnements impactant les IDG 103.

L'entraînement est effectué selon deux axes de classification. Un premier axe de classification concerne la détection ou la prédiction de dysfonctionnement d'IDG 103. Un second axe de classification concerne, en cas de détection ou prédiction de dysfonctionnement d'IDG 103, la prédiction de cause du dysfonctionnement d'IDG 103.

Pour ce faire, dans une étape 212, le système d'analyse de données effectue une première passe de classification sur le jeu de données injectées. La classification entraînée pour cette première passe concerne la détection ou la prédiction de dysfonctionnement d'IDG 103. Par exemple, la première passe est réalisée grâce à un premier algorithme décisionnel. Dans un mode de réalisation particulier, la première passe est réalisée avec un algorithme de type LightGBM (« Light Gradient Boosting Machine » en anglais). LightGBM est bien adapté à la première passe, de par sa rapidité d'exécution et sa fiabilité avec un jeu de données d'entrée conséquent (disponibilité de rapports de pannes issus de vols antérieurs).

Ainsi, dans une étape 213, en fonction de la première passe, le système d'analyse de données obtient une prédiction quant au dysfonctionnement de l'IDG 103 concerné, pour les données injectées, au vu de l'annotation fournie pour l'entraînement.

Pour pouvoir apprendre la cause des dysfonctionnements, le cas échéant, le système d'analyse de données effectue une seconde passe de classification sur une sélection (étape 214) parmi le jeu de données, la sélection correspondant aux données injectées qui ont été annotées comme représentatives d'un dysfonctionnement de l'IDG 103. Par exemple, la seconde passe est réalisée grâce à un second algorithme décisionnel différent du premier algorithme décisionnel. Dans un mode de réalisation particulier, la seconde passe est réalisée avec un algorithme de type XGBoost. XGBoost est bien adapté à la seconde passe de par sa plus grande fiabilité avec un jeu de données d'entrée plus restreint (dû à la sélection suite à la première passe).

Ainsi, dans une étape 216, en fonction de la seconde passe, le système d'analyse de données obtient une prédiction quant à la cause du dysfonctionnement de l'IDG 103 concerné, pour les données injectées, au vu de l'annotation fournie pour l'entraînement.

Afin de vérifier que l'intelligence artificielle de type apprentissage machine a été configurée de manière adéquate par l'entraînement réalisé, un nouveau cycle est réalisé, dans lequel le jeu de données de validation est injecté dans l'étape 211. Dans le cadre de la validation, les données injectées ne subissent pas d'annotation, et l'intelligence artificielle de type apprentissage machine effectue d'elle-même la classification attendue par les première et seconde passes. Si l'intelligence artificielle de type apprentissage machine effectue la classification telle qu'attendue, alors le système d'analyse de données peut être mise en production, c'est-à-dire utilisé pour détecter d'éventuels dysfonctionnements d'un générateur d'entraînement intégré et, auquel cas, d'en trouver les causes. ; sinon, un nouvel entraînement doit être réalisé.

Ainsi, grâce à un entraînement adapté, l'intelligence artificielle de type apprentissage machine peut être aisément configurée, en s'appuyant sur des rapports de pannes issus de vols antérieurs, pour détecter des dysfonctionnements d'IDG 103 liés à :
- Une anomalie de contrôle d'ouverture/fermeture de FRV 104 ;
- Un colmatage d'huile d'IDG 103 ;
- Une défaillance de capteur de température en port de sortie d'IDG 103 ;
- Une défaillance de capteur de température en port d'entrée d'IDG 103 ;
- Une fuite d'huile d'IDG 103 ;
- Une anomalie d'entretien d'IDG 103.

L'intelligence artificielle de type apprentissage machine peut être entraînée pour détecter d'autres types de causes de dysfonctionnements d'IDG 103.

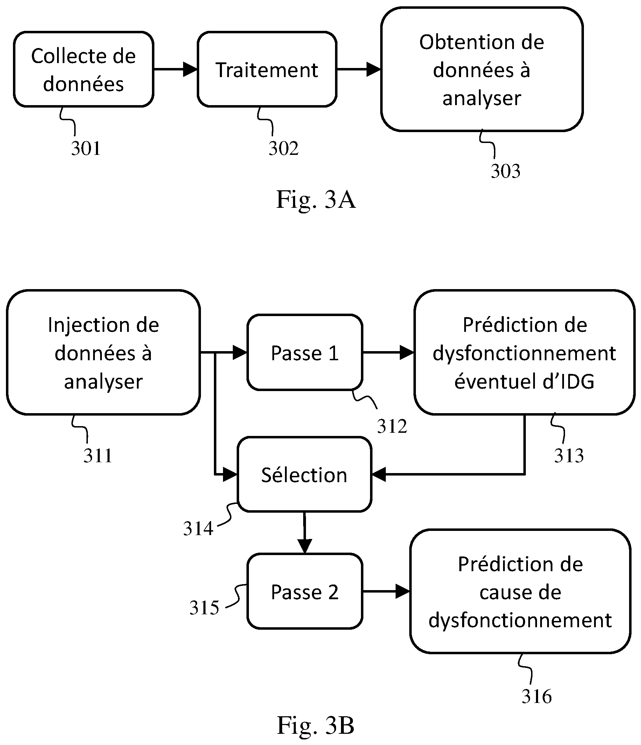

La **Fig. 3A** illustre schématiquement un algorithme d'obtention de données à analyser par l'intelligence artificielle de type apprentissage machine.

Une fois le système d'analyse de données en production, le but de son utilisation est de détecter ou de prédire la survenue d'un dysfonctionnement d'IDG 103, et auquel cas, d'en établir la cause.

Des mesures sont réalisées pendant les vols d'aéronefs afin de collecter, dans une étape 301, des données permettant de surveiller chaque IDG 103 desdits aéronefs. Les mesures en question fournissent des données du même type que celles collectées à l'étape 201 pour initier l'entraînement de l'intelligence artificielle de type apprentissage machine.

Dans une étape 302, le système d'analyse de données effectue un traitement sur les données collectées à l'étape 301. Le traitement appliqué à l'étape 302 est identique à celui appliqué à l'étape 202, afin d'obtenir dans une étape 303 des données à analyser de même type et de même nature que celles obtenues à l'étape 203.

La **Fig. 3B** illustre schématiquement un algorithme d'analyse de données par l'intelligence artificielle de type apprentissage machine.

Dans une étape 311, le système d'analyse de données injecte des données à analyser, telles qu'obtenues à l'étape 303, en entrée de l'intelligence artificielle de type apprentissage machine. Contrairement à la phase d'entraînement, il n'est pas ici connu si les données sont révélatrices d'un dysfonctionnement subi par l'IDG 103 concerné ou pas.

Dans une étape 312, le système d'analyse de données effectue une première passe de classification sur les données injectées. Comme pour l'entraînement, cette première passe concerne la détection ou la prédiction de dysfonctionnement de l'IDG 103 concerné par les données injectées. La première passe est réalisée grâce au même algorithme que pour l'entraînement (premier algorithme), à la différence qu'en production, l'intelligence artificielle de type apprentissage machine a été entraînée pour détecter ou prédire d'elle-même un dysfonctionnement d'IDG 103 à partir des données injectées (données à analyser).

Ainsi, dans une étape 313, en fonction de la première passe, le système d'analyse de données obtient une prédiction quant au dysfonctionnement de l'IDG 103 concerné, pour les données injectées, au vu de l'entraînement réalisé.

Lorsque la première passe révèle que les données injectées sont révélatrices d'un dysfonctionnement subi par l'IDG 103, les données injectées correspondantes sont sélectionnées dans une étape 314 afin de subir une seconde passe dans une étape 315. La seconde passe est réalisée grâce au même algorithme que pour l'entraînement (second algorithme), à la différence qu'en production, l'intelligence artificielle de type apprentissage machine a été entraînée pour trouver d'elle-même la cause du dysfonctionnement à partir des données injectées (données à analyser).

Ainsi, dans une étape 316, en fonction de la seconde passe, le système d'analyse de données obtient une prédiction quant à la cause du dysfonctionnement de l'IDG 103 concerné, pour les données injectées, au vu de l'entraînement réalisé.

Ainsi, le système d'analyse de données est apte à déterminer, à partir de données collectées en vol et à partir de l'intelligence artificielle de type apprentissage machine qui a été entraînée comme précédemment décrit, si un dysfonctionnement de l'IDG 103 est survenu ou est en passe de survenir, et auquel cas, quelle en est la cause. La maintenance autour de l'IDG 103 est alors grandement facilitée.

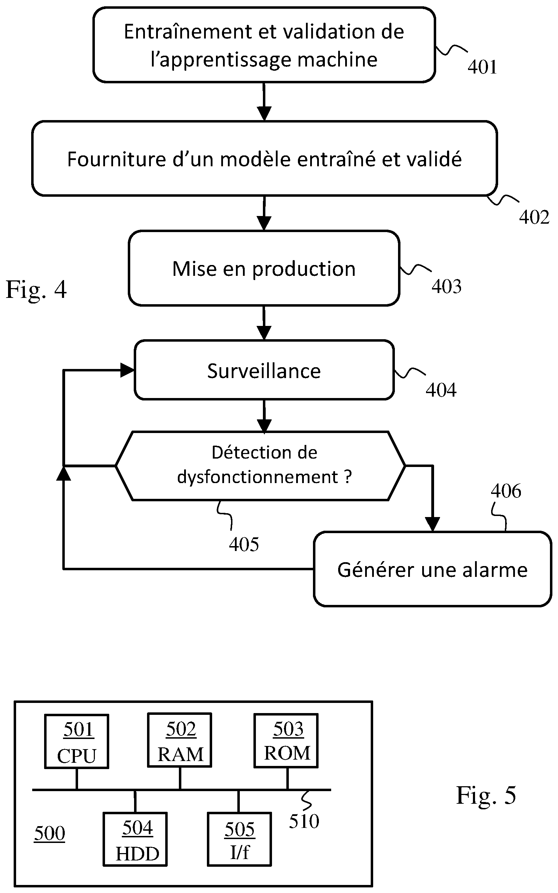

La **Fig. 4** illustre schématiquement un algorithme de configuration et d'utilisation de l'intelligence artificielle de type apprentissage machine dans le cadre du système d'analyse de données.

Dans une étape 401, l'intelligence artificielle de type apprentissage machine est entraînée et validée comme précédemment décrit en relation avec les Figs. 2A et 2B.

Dans une étape 402, suite à l'entraînement et à la validation, un modèle entraîné et validé est obtenu, permettant une mise en production de l'intelligence artificielle de type apprentissage machine dans une étape 403.

Dans une étape 404, une phase de surveillance est effectuée. La phase de surveillance consiste en la collecte de données lors de vols d'aéronefs afin de surveiller le bon fonctionnement de chaque IDG 103 desdits aéronefs, ainsi qu'en l'analyse des données collectées. La collecte de données et l'analyse des données collectées sont effectuées comme précédemment décrit en relation avec les Figs. 3A et 3B.

Ainsi, le système d'analyse de données peut équiper chaque aéronef concerné, et être préférentiellement intégré dans l'avionique 101 dudit aéronef. En variante, le système d'analyse de données est un équipement informatique au sol dans un centre de contrôle, par exemple dans des locaux d'une compagnie aérienne. Alors, les données à collecter sont transmises par l'avionique 101 à l'équipement informatique du centre de contrôle, par exemple grâce à des communications sol-air, ou en utilisant un bagage électronique de vol EFB (« Electronic Flying Bag » en anglais) comme intermédiaire entre l'avionique 101 et l'équipement informatique du centre de contrôle. Le bagage électronique de vol EFB utilise alors des communications filaires (par exemple, de type USB) ou sans-fil (par exemple, de type Bluetooth ou Wi-Fi)) pour échanger avec l'équipement informatique du centre de contrôle et l'avionique 101.

Dans une étape 405, le système d'analyse de données détermine si l'analyse des données collectées montre un dysfonctionnement d'IDG 103. Si tel est le cas, une étape 406 est effectuée ; sinon, la surveillance est poursuivie dans l'étape 404.

Dans l'étape 406, le système d'analyse de données génère une alarme représentative du dysfonctionnement d'IDG 103 détecté (détection grâce à la première passe). L'alarme est accompagnée d'une information indiquant la cause supposée du dysfonctionnement détecté (identification grâce à la seconde passe). Une maintenance peut alors être programmée, et la surveillance est poursuivie dans l'étape 404.

La **Fig. 5** illustre schématiquement un exemple d'une plateforme matérielle 500 du système d'analyse de données, sous forme de circuiterie électronique, qui est adaptée et configurée pour implémenter les algorithmes décrits ci-dessus. La plateforme matérielle 500 est ainsi adaptée et configurée pour implémenter l'intelligence artificielle de type apprentissage machine divulguée ici.

La plateforme matérielle 500 comporte alors, reliés par un bus de communication 510 : un processeur ou CPU (« Central Processing Unit » en anglais) 501 ; une mémoire vive RAM (« Read-Only Memory » en anglais) 502 ; une mémoire morte 503, par exemple de type ROM (« Read Only Memory » en anglais) ou EEPROM (« Electrically-Erasable Programmable ROM » en anglais) ; une unité de stockage 504, telle qu'un disque dur HDD (« Hard Disk Drive » en anglais), ou un lecteur de support de stockage, tel qu'un lecteur de cartes SD (« Secure Digital » en anglais) ; et un gestionnaire d'interfaces I/f 505.

Le gestionnaire d'interfaces I/f 505 permet d'interagir avec un ou plusieurs équipements de l'aéronef 10, tels que les capteurs de température susmentionnés, et/ou éventuellement avec un réseau de communication. Par exemple, le gestionnaire d'interfaces I/f 505 est adapté et configuré pour permettre d'interagir avec l'avionique 101.

Le processeur 501 est capable d'exécuter des instructions chargées dans la mémoire vive 502 à partir de la mémoire morte 503, d'une mémoire externe, d'un support de stockage (tel qu'une carte SD), ou d'un réseau de communication. Lorsque la plateforme matérielle 500 est mise sous tension, le processeur 501 est capable de lire de la mémoire vive 502 des instructions et de les exécuter. Ces instructions forment un programme d'ordinateur causant l'implémentation, par le processeur 501, de tout ou partie des étapes et fonctionnements décrits ici.

Tout ou partie des étapes et fonctionnements décrits ici peut ainsi être implémenté sous forme logicielle par exécution d'un ensemble d'instructions par une machine programmable, par exemple un processeur de type DSP (« Digital Signal Processor » en anglais) ou un microcontrôleur, ou être implémenté sous forme matérielle par une machine ou un composant électronique (« chip » en anglais) dédié ou un ensemble de composants électroniques (« chipset » en anglais) dédié, par exemple un composant FPGA (« Field Programmable Gate Array » en anglais) ou ASIC (« Application Specific Integrated Circuit » en anglais). D'une manière générale, la plateforme matérielle 500 comporte de la circuiterie électronique adaptée et configurée pour implémenter les fonctionnements et étapes décrits ici.

## Revendications

1. Procédé de détection de dysfonctionnement subi par un générateur d'entraînement intégré, dit IDG (103) à surveiller, dans un aéronef (10), le procédé étant implémenté par un système d'analyse de données comportant une intelligence artificielle de type apprentissage machine, **caractérisé en ce que** le procédé comporte les étapes suivantes :
- collecter (201) des données de référence relatives à des mesures effectuées et enregistrées pendant des vols antérieurs d'aéronefs équipés d'IDG (103), dits IDG de référence, les données de référence comportant au moins des mesures correspondant aux paramètres suivants, pour chaque IDG (103) de référence :
- Débit de carburant pour alimenter un moteur de propulsion (102) auquel l'IDG (103) de référence en question est associé ;
- Position d'une vanne de retour carburant (104) associée à l'IDG (103) de référence en question ;
- Température mesurée par un capteur en port d'entrée de l'IDG (103) de référence en question ;
- Température mesurée par un capteur en port de sortie de l'IDG (103) de référence en question ;
- Fréquence de signal électrique produit par l'IDG (103) de référence en question ;
- Température d'huile alimentant le moteur de propulsion (102) auquel l'IDG (103) de référence en question est associé ;
- effectuer un entraînement (401), en mode supervisé, l'intelligence artificielle de type apprentissage machine grâce aux données de référence, avec une première passe (212) de classification pour entraîner à détecter d'éventuels dysfonctionnements subis par des IDG (103) et une seconde passe (215) de classification pour entraîner à déterminer des causes des dysfonctionnements le cas échéant ;
- mettre en production (403) l'intelligence artificielle de type apprentissage machine après validation de l'entraînement ;
- collecter (301) des données à analyser, de même type que les données de référence, relatives à des mesures effectuées et enregistrées pendant des vols de l'aéronef comportant l'IDG (103) à surveiller ;
- utiliser l'intelligence artificielle de type apprentissage machine qui a été entraînée, et prédire (313) ainsi un éventuel dysfonctionnement subi par l'IDG (103) à surveiller et prédire (316), le cas échéant, une cause des dysfonctionnements, grâce respectivement auxdites première et deuxième passes, à partir des données à analyser.

2. Procédé selon la revendication 1, dans lequel les données de référence comportent en outre des mesures correspondant à au moins l'un des paramètres suivants, pour chaque IDG (103) de référence :
- Durée durant laquelle la vanne de retour carburant (104) est ouverte ;
- Durée durant laquelle la vanne de retour carburant (104) est fermée ;
- Rapport entre la durée durant laquelle la vanne de retour carburant (104) est fermée et la durée durant laquelle la vanne de retour carburant est ouverte ;
- Durée mise par la vanne de retour carburant (104) pour passer de position fermée à position ouverture ;
- Différence de température entre port d'entrée de l'IDG (103) de référence en question et port de sortie de l'IDG (103) de référence en question.

3. Procédé selon la revendication 1 ou 2, dans lequel le système d'analyse de données applique un traitement sur les données de référence et sur les données à analyser, le traitement appliqué correspondant au moins au calcul des informations suivantes, éventuellement en combinaison, pour un ou plusieurs desdits paramètres :
- Valeur minimum ;
- Valeur maximum ;
- Ecart-type ;
- Moyenne ;
- Moyenne glissante ;
- Coefficient directeur de pente.

4. Procédé selon la revendication 3, dans lequel le calcul d'au moins une partie desdites informations est réalisé en regroupant des données de référence, et respectivement des données à analyser, sur plusieurs vols consécutifs d'aéronefs.

5. Procédé selon l'une quelconque des revendications 1 à 4, dans lequel l'intelligence artificielle de type apprentissage machine est entraînée pour détecter un dysfonctionnement d'IDG (103) lié à :
- Une anomalie de contrôle d'ouverture/fermeture de vanne de retour carburant (104) ;
- Un colmatage d'huile d'IDG (103) ;
- Une défaillance de capteur de température en port de sortie d'IDG (103) ;
- Une défaillance de capteur de température en port d'entrée d'IDG (103) ;
- Une fuite d'huile d'IDG (103) ;
- Une anomalie d'entretien d'IDG (103).

6. Procédé selon l'une quelconque des revendications 1 à 5, dans lequel la première passe de classification est effectuée en appliquant un premier algorithme et la seconde passe de classification est effectuée en appliquant un second algorithme distinct du premier algorithme.

7. Procédé selon la revendication 6, dans lequel le premier algorithme est de type LightGBM et le second algorithme est de type XGBooost.

8. Procédé selon l'une quelconque des revendications 1 à 7, dans lequel l'intelligence artificielle de type apprentissage machine est mise en production dans une avionique (101) de l'aéronef (10) équipé de l'IDG (103) à surveiller.

9. Procédé selon l'une quelconque des revendications 1 à 7, dans lequel l'intelligence artificielle de type apprentissage machine est mise en production dans un équipement informatique au sol dans un centre de contrôle, et dans lequel les données à analyser sont transmises par une avionique (101) de l'aéronef (10) équipé de l'IDG (103) à surveiller à l'équipement informatique du centre de contrôle.

10. Produit programme d'ordinateur, comportant des instructions entraînant l'exécution, par un processeur (501), du procédé selon l'une quelconque des revendications 1 à 9, lorsque lesdites instructions sont exécutées par le processeur (501).

11. Support de stockage, stockant un programme d'ordinateur comportant des instructions entraînant l'exécution, par un processeur (501), du procédé selon l'une quelconque des revendications 1 à 9, lorsque lesdites instructions sont lues et exécutées par le processeur (501).

12. Système d'analyse de données comportant une intelligence artificielle de type apprentissage machine, le système comportant une circuiterie électronique configurée pour effectuer une détection de dysfonctionnement subi par un générateur d'entraînement intégré, dit IDG (103) à surveiller, dans un aéronef (10), **caractérisé en ce que** la circuiterie électronique est configurée pour :
- collecter (201) des données de référence relatives à des mesures effectuées et enregistrées pendant des vols antérieurs d'aéronefs équipés d'IDG (103), dits IDG de référence, les données de référence comportant au moins des mesures correspondant aux paramètres suivants, pour chaque IDG (103) de référence :
- Débit de carburant pour alimenter un moteur de propulsion (102) auquel l'IDG (103) de référence en question est associé ;
- Position d'une vanne de retour carburant (104) associée à l'IDG (103) de référence en question ;
- Température mesurée par un capteur en port d'entrée de l'IDG (103) de référence en question ;
- Température mesurée par un capteur en port de sortie de l'IDG (103) de référence en question ;
- Fréquence de signal électrique produit par l'IDG (103) de référence en question ;
- Température d'huile alimentant le moteur de propulsion (102) auquel l'IDG (103) de référence en question est associé ;
- effectuer un entraînement (401), en mode supervisé, l'intelligence artificielle de type apprentissage machine grâce aux données de référence, avec une première passe (212) de classification pour entraîner à détecter d'éventuels dysfonctionnements subis par des IDG (103) et une deuxième passe (215) de classification pour entraîner à déterminer des causes des dysfonctionnements le cas échéant ;
- mettre en production (403) l'intelligence artificielle de type apprentissage machine après validation de l'entraînement ;
- collecter (301) des données à analyser, de même type que les données de référence, relatives à des mesures effectuées et enregistrées pendant des vols de l'aéronef comportant l'IDG (103) à surveiller ;
- utiliser l'intelligence artificielle de type apprentissage machine qui a été entraînée, et prédire (313) ainsi un éventuel dysfonctionnement subi par l'IDG (103) à surveiller et prédire (316), le cas échéant, une cause des dysfonctionnements, grâce respectivement auxdites première et deuxième passes, à partir des données à analyser.

## Patentansprüche

1. Verfahren zur Erkennung einer Fehlfunktion eines integrierten Antriebsgenerators, zu überwachender IDG (103) genannt, in einem Flugzeug (10), wobei das Verfahren von einem Datenanalysesystem implementiert wird, das eine künstliche Intelligenz vom Typ maschinelles Lernen umfasst, **dadurch gekennzeichnet, dass** das Verfahren die folgenden Schritte umfasst:
- Sammeln (201) von Referenzdaten bezüglich von Messungen, die bei früheren Flüge von Flugzeugen, die mit einem IDG (103) ausgestattet sind, Referenz-IDG genannt, durchgeführt und gespeichert wurden, wobei die Referenzdaten für jeden Referenz-IDG (103) mindestens Messungen umfassen, die den folgenden Parametern entsprechen:
- Kraftstoffdurchsatz zur Versorgung eines Triebwerks (102), dem der betreffende Referenz-IDG (103) zugeordnet ist;
- Position eines Kraftstoffrücklaufventils (104), das dem betreffenden Referenz-IDG (103) zugeordnet ist;
- Temperatur, die von einem Sensor im Eingangsport des betreffenden Referenz-IDG (103) gemessen wird;
- Temperatur, die von einem Sensor im Ausgangsport des betreffenden Referenz-IDG (103) gemessen wird;
- Frequenz eines elektrischen Signals, das von dem betreffenden Referenz-IDG (103) erzeugt wird;
- Temperatur des Öls, welches das Triebwerk (102) versorgt, dem der betreffende Referenz-IDG (103) zugeordnet ist;
- Durchführen eines Trainings (401) im überwachten Modus der künstlichen Intelligenz vom Typ maschinelles Lernen mithilfe der Referenzdaten mit einem ersten Klassifikationsdurchgang (212), um zu trainieren, etwaige Fehlfunktionen der IDG (103) zu erkennen, und einem zweiten Klassifikationsdurchgang (215), um zu trainieren, gegebenenfalls Ursachen für die Fehlfunktionen zu ermitteln;
- Überführen in den produktiven Betrieb (403) der künstlichen Intelligenz vom Typ maschinelles Lernen nach Validierung des Trainings;
- Sammeln (301) von zu analysierenden Daten, vom selben Typ wie die Referenzdaten, bezüglich von Messungen, die bei Flügen des Flugzeugs mit dem zu überwachenden IDG (103) durchgeführt und gespeichert werden;
- Verwenden der künstlichen Intelligenz vom Typ maschinelles Lernen, die trainiert worden ist, und Vorhersagen (313) einer etwaigen Fehlfunktion des zu überwachenden IDG (103) und Vorhersagen (316) gegebenenfalls einer Ursache für die Fehlfunktionen mithilfe der ersten beziehungsweise zweiten Durchgänge ausgehend von den zu analysierenden Daten.

2. Verfahren nach Anspruch 1, wobei die Referenzdaten ferner Messungen, die mindestens einem der folgenden Parameter entsprechen, für jeden Referenz-IDG (103) umfassen:
- Dauer, während der das Kraftstoffrücklaufventil (104) geöffnet ist;
- Dauer, während der das Kraftstoffrücklaufventil (104) geschlossen ist;
- Verhältnis zwischen der Dauer, während der das Kraftstoffrücklaufventil (104) geschlossen ist, und der Dauer, während der das Kraftstoffrücklaufventil geöffnet ist;
- Dauer, die das Kraftstoffrücklaufventil (104) benötigt, um von der geschlossenen Stellung in die Öffnungsstellung überzugehen;
- Temperaturunterschied zwischen Eingangsport des betreffenden Referenz-IDG (103) und Ausgangsport des betreffenden Referenz-IDG (103).

3. Verfahren nach Anspruch 1 oder 2, wobei das Datenanalysesystem eine Verarbeitung auf die Referenzdaten und auf die zu analysierenden Daten anwendet, wobei die angewandte Verarbeitung mindestens der Berechnung der folgenden Informationen, gegebenenfalls in Kombination, für einen oder mehrere der Parameter entspricht:
- Kleinster Wert;
- Größter Wert;
- Standardabweichung;
- Mittelwert;
- Gleitender Mittelwert;
- Steigung.

4. Verfahren nach Anspruch 3, wobei die Berechnung mindestens eines Teils der Informationen ausgeführt wird, indem Referenzdaten und zu analysierende Daten für mehrere aufeinander folgende Flüge von Flugzeugen zusammengefasst werden.

5. Verfahren nach einem der Ansprüche 1 bis 4, wobei die künstliche Intelligenz vom Typ maschinelles Lernen trainiert wird, um eine Fehlfunktion eines IDG (103) zu erkennen, die zusammenhängt mit:
- einem Steuerungsfehler beim Öffnen/Schließen des Kraftstoffrücklaufventils (104);
- einer Verunreinigung des Öls des IDG (103);
- einem Ausfall eines Temperatursensors im Ausgangsport des IDG (103);
- einem Ausfall eines Temperatursensors im Eingangsport des IDG (103);
- einer Ölleckage des IDG (103);
- einem Wartungsfehler des IDG (103).

6. Verfahren nach einem der Ansprüche 1 bis 5, wobei der erste Klassifikationsdurchgang durchgeführt wird, indem ein erster Algorithmus angewandt wird, und der zweite Klassifikationsdurchgang durchgeführt wird, indem ein zweiter Algorithmus angewandt wird, der von dem ersten Algorithmus verschieden ist.

7. Verfahren nach Anspruch 6, wobei der erste Algorithmus vom Typ LightGBM ist und der zweite Algorithmus vom Typ XGBooost ist.

8. Verfahren nach einem der Ansprüche 1 bis 7, wobei die künstliche Intelligenz vom Typ maschinelles Lernen in einer Avionik (101) des Flugzeugs (10, das mit dem zu überwachenden IDG (103) ausgestattet ist, in den produktiven Betrieb überführt wird.

9. Verfahren nach einem der Ansprüche 1 bis 7, wobei die künstliche Intelligenz vom Typ maschinelles Lernen in einem Computersystem am Boden in einem Kontrollzentrum in den produktiven Betrieb überführt wird und wobei die zu analysierenden Daten von einer Avionik (101) des Flugzeugs (10), das mit dem zu überwachenden IDG (103) ausgestattet ist, an das Computersystem des Kontrollzentrums übermittelt werden.

10. Computerprogrammprodukt, das Anweisungen umfasst, die die Ausführung des Verfahrens nach einem der Ansprüche 1 bis 9 durch einen Prozessor (501) bewirken, wenn die Anweisungen von dem Prozessor (501) ausgeführt werden.

11. Speichermedium, das ein Computerprogramm speichert, das Anweisungen umfasst, die die Ausführung des Verfahrens nach einem der Ansprüche 1 bis 9 durch einen Prozessor (501) bewirken, wenn die Anweisungen von dem Prozessor (501) gelesen und ausgeführt werden.

12. Datenanalysesystem, das ein künstliche Intelligenz vom Typ maschinelles Lernen umfasst, wobei das System eine elektronische Schaltungsanordnung umfasst, die dazu ausgestaltet ist, eine Erkennung einer Fehlfunktion eines integrierten Antriebsgenerators, zu überwachender IDG (103) genannt, in einem Flugzeug (10) durchzuführen, **dadurch gekennzeichnet, dass** die elektronische Schaltungsanordnung ausgestaltet ist zum:
- Sammeln (201) von Referenzdaten bezüglich von Messungen, die bei früheren Flüge von Flugzeugen, die mit einem IDG (103) ausgestattet sind, Referenz-IDG genannt, durchgeführt und gespeichert wurden, wobei die Referenzdaten für jeden Referenz-IDG (103) mindestens Messungen umfassen, die den folgenden Parametern entsprechen:
- Kraftstoffdurchsatz zur Versorgung eines Triebwerks (102), dem der betreffende Referenz-IDG (103) zugeordnet ist;
- Position eines Kraftstoffrücklaufventils (104), das dem betreffenden Referenz-IDG (103) zugeordnet ist;
- Temperatur, die von einem Sensor im Eingangsport des betreffenden Referenz-IDG (103) gemessen wird;
- Temperatur, die von einem Sensor im Ausgangsport des betreffenden Referenz-IDG (103) gemessen wird;
- Frequenz eines elektrischen Signals, das von dem betreffenden Referenz-IDG (103) erzeugt wird;
- Temperatur des Öls, welches das Triebwerk (102) versorgt, dem der betreffende Referenz-IDG (103) zugeordnet ist;
- Durchführen eines Trainings (401) im überwachten Modus der künstlichen Intelligenz vom Typ maschinelles Lernen mithilfe der Referenzdaten mit einem ersten Klassifikationsdurchgang (212), um zu trainieren, etwaige Fehlfunktionen der IDG (103) zu erkennen, und einem zweiten Klassifikationsdurchgang (215), um zu trainieren, gegebenenfalls Ursachen für die Fehlfunktionen zu ermitteln;
- Überführen in den produktiven Betrieb (403) der künstlichen Intelligenz vom Typ maschinelles Lernen nach Validierung des Trainings;
- Sammeln (301) von zu analysierenden Daten, vom selben Typ wie die Referenzdaten, bezüglich von Messungen, die bei Flügen des Flugzeugs mit dem zu überwachenden IDG (103) durchgeführt und gespeichert werden;
- Verwenden der künstlichen Intelligenz vom Typ maschinelles Lernen, die trainiert worden ist, und Vorhersagen (313) einer etwaigen Fehlfunktion des zu überwachenden IDG (103) und Vorhersagen (316) gegebenenfalls einer Ursache für die Fehlfunktionen mithilfe der ersten beziehungsweise zweiten Durchgänge ausgehend von den zu analysierenden Daten.

## Claims

1. Method for detecting a malfunction suffered by an integrated drive generator, referred to as IDG (103) to be monitored, in an aircraft (10), the method being implemented by a data analysis system comprising an artificial intelligence of the machine learning type, **characterized in that** the method comprises the following steps:
- collecting (201) reference data relating to measurements made and recorded during previous flights of aircraft equipped with IDGs (103), called reference IDGs, the reference data comprising at least measurements corresponding to the following parameters, for each reference IDG (103):
- Flow of fuel supplying a jet engine (102) with which the reference IDG (103) in question is associated;
- Position of a fuel return valve (104) associated with the reference IDG (103) in question;
- Temperature measured by a sensor on the inlet port of the reference IDG (103) in question;
- Temperature measured by a sensor on the outlet port of the reference IDG (103) in question;
- Frequency of electrical signal produced by the reference IDG (103) in question;
- Temperature of oil supplying the jet engine (102) with which the reference IDG (103) in question is associated;
- carrying out a training (401), in supervisor mode, of the artificial intelligence of the machine learning type by virtue of the reference data, with a first classification run (212) for training to detect potential malfunctions suffered by IDGs (103) and a second classification run (215) for training to determine causes of the malfunctions where relevant;
- using in production (403) the artificial intelligence of the machine learning type after validation of the training;
- collecting (301) data to be analysed, of the same type as the reference data, relating to measurements made and recorded during flights of the aircraft comprising the IDG (103) to be monitored;
- using the artificial intelligence of the machine learning type that has been trained, and thus predicting (313) a potential malfunction suffered by the IDG (103) to be monitored and predicting (316), where relevant, a cause of the malfunctions by virtue, respectively, of the said first and second runs, using the data to be analysed.

2. Method according to Claim 1, in which the reference data furthermore comprise measurements corresponding to at least one of the following parameters, for each reference IDG (103):
- Time during which the fuel return valve (104) is open;
- Time during which the fuel return valve (104) is closed;
- Ratio between the time during which the fuel return valve (104) is closed and the time during which the fuel return valve is open;
- Time taken by the fuel return valve (104) to go from the closed position to the open position;
- Difference in temperature between the inlet port of the reference IDG (103) in question and outlet port of the reference IDG (103) in question.

3. Method according to Claim 1 or 2, in which the data analysis system applies a processing to the reference data and to the data to be analysed, the processing applied corresponding at least to the calculation of the following information, potentially in combination, for one or more of the said parameters:
- Minimum value;
- Maximum value;
- Standard deviation;
- Average;
- Moving average;
- Gradient coefficient.

4. Method according to Claim 3, in which the calculation of at least a part of the said information is carried out by grouping reference data and, respectively, data to be analysed, over several consecutive aircraft flights.

5. Method according to any one of Claims 1 to 4, in which the artificial intelligence of the machine learning type is trained to detect an IDG (103) malfunction linked to:
- An anomaly in the opening/closing controls of a fuel return valve (104);
- A clogging of IDG (103) oil;
- A failure of a temperature sensor on the IDG (103) outlet port;
- A failure of a temperature sensor on the IDG (103) inlet port;
- An oil leak in an IDG (103);
- An anomaly of IDG (103) maintenance.

6. Method according to any one of Claims 1 to 5, in which the first classification run is carried out by applying a first algorithm and the second classification run is carried out by applying a second algorithm distinct from the first algorithm.

7. Method according to Claim 6, in which the first algorithm is of the LightGBM type and the second algorithm is of the XGBooost type.

8. Method according to any one of Claims 1 to 7, in which the artificial intelligence of the machine learning type is used in production in an avionics system (101) of the aircraft (10) equipped with the IDG (103) to be monitored.

9. Method according to any one of Claims 1 to 7, in which the artificial intelligence of the machine learning type is used in production in a computer system on the ground in a control centre, and in which the data to be analysed are transmitted by an avionics system (101) of the aircraft (10), equipped with the IDG (103) to be monitored, to the computer system in the control centre.

10. Computer program product, comprising instructions leading to the execution, by a processor (501), of the method according to any one of Claims 1 to 9, when the said instructions are executed by the processor (501).

11. Storage medium, storing a computer program comprising instructions leading to the execution, by a processor (501), of the method according to any one of Claims 1 to 9, when the said instructions are read and executed by the processor (501).

12. Data analysis system comprising an artificial intelligence of the machine learning type, the system comprising an electronic circuitry configured to carry out a detection of a malfunction suffered by an integrated drive generator, referred to as IDG (103) to be monitored, in an aircraft (10), **characterized in that** the electronic circuitry is configured for:
- collecting (201) reference data relating to measurements made and recorded during previous flights of aircraft equipped with IDGs (103), called reference IDGs, the reference data comprising at least measurements corresponding to the following parameters, for each reference IDG (103):
- Flow of fuel supplying a jet engine (102) with which the reference IDG (103) in question is associated;
- Position of a fuel return valve (104) associated with the reference IDG (103) in question;
- Temperature measured by a sensor on the inlet port of the reference IDG (103) in question;
- Temperature measured by a sensor on the outlet port of the reference IDG (103) in question;
- Frequency of electrical signal produced by the reference IDG (103) in question;
- Temperature of oil supplying the jet engine (102) with which the reference IDG (103) in question is associated;
- carrying out a training (401), in supervisor mode, of the artificial intelligence of the machine learning type by virtue of the reference data, with a first classification run (212) for training to detect potential malfunctions suffered by IDGs (103) and a second classification run (215) for training to determine causes of the malfunctions, where relevant;
- using in production (403) the artificial intelligence of the machine learning type after validation of the training;
- collecting (301) data to be analysed, of the same type as the reference data, relating to measurements made and recorded during flights of the aircraft comprising the IDG (103) to be monitored;
- using the artificial intelligence of the machine learning type that has been trained, and thus predicting (313) a potential malfunction suffered by the IDG (103) to be monitored and predicting (316), where relevant, a cause of the malfunctions by virtue, respectively, of the said first and second runs, using the data to be analysed.
